# EUROPEAN PATENT APPLICATION

(11) **EP 0 899 575 A2**
(43) Date of publication of application: **03.03.1999**
(21) Application number: 98660081.5
(22) Date of filing: 24.08.1998
(51) Int. Cl.: G01R 29/18

(54) **A method and device for measuring the phase sequence and rotational direction of a three-phase system**

(30) Priority: 27.08.1997 FI 973532
(71) Applicant: Ensto Sekko Oy, 06101 Porvoo (FI)
(72) Inventor: Alahuhtala, Jorma, 27800 Säkylä (FI)
(74) Representative: Hiltunen, Pentti Juhani

(57) **Abstract**

A device and a method for measuring the phase sequence and the rotation direction of a three-phase system. The device comprises a measuring sensor (28, 32), a processor (34) and a display part (36). The processor comprises a synchronisation program section, which comprises functions for calculating the average T of the pulse period of the synchronising phase and for measuring the pulse length t and storing it in the memory, and for calculating the values t/2 and T/3 and storing them in the memory. Further the processor comprises a comparison program section, which comprises functions for detecting a square pulse of the synchronising phase received at the moment t/2 and at the moment T/3 from the measuring sensor, and functions for lighting a signal in the display part when a square pulse has been detected in the reference phase.

## Description

The present invention relates to the method and the device presented in the preambles of the independent claims presented below.

Then the invention relates particularly to such a method and a device for measuring the phase sequence and rotation direction of a three-phase system, whereby the device comprises
- a measuring sensor having a switch circuit in order to transform the voltage generated in the measuring sensor into square pulses,
- a microprocessor for processing the square pulses received from the measuring sensor, whereby the measuring sensor outputs are connected to the microprocessor, which on the basis of the phase difference between the square pulses detects the rotation direction, and
- a display part having means, such as LEDs indicating the rotation direction.

When electrical devices are connected to a three-phase system it is important to know the voltage rotation direction, so that it will be for instance possible to obtain the desired rotation direction of a device to be connected. From the Finnish patent FI 93998 it is previously known to measure the voltage rotation direction by placing in each examined phase a measuring sensor which operates according to the electrostatic principle and which is connected to a phase comparator. On the basis of the signals provided by the different measuring sensors the phase comparator in this known solution is able to measure the phase differences between the different phases and to deduce the voltage rotation direction from them.

However, it would of course be simpler if it would be possible to make the measurement by utilising only one measuring sensor. Then it would be possible to construct a measuring device which is smaller and handier than before. By arranging the measuring sensor and the required electronics into one hand-held device one could avoid cumbersome intermediate cables as well as problems caused by the mounting of the measuring sensors.

It is true that previously there has been proposed to use a single-pole phase comparator in order to examine whether the examined conductors have the same phase. Then the sensor part of the measuring device is brought into galvanic contact with the examined conductor, whereby the device synchronises its internal oscillator to the frequency to be measured. When the measuring device is brought into galvanic contact with another conductor the measuring device indicates whether both conductors had the same phase or a different phases. The device will not report whether the new phase is in advance of or behind the previous phase, i.e. the information provided by the measuring device can not be used to determine the phase sequence and the rotation direction of the voltage.

The object of the present invention is to provide a method and a device, which are better and simpler to use for measuring the phase sequence and the rotation direction of a three-phase system.

The object is then particularly to provide a single-pole measuring method and device.

The object is also to provide a light-weight and handy measuring device, which can be brought close to a three-phase line held in one hand.

In order to achieve the above mentioned objects the device and the method according to the invention are characterised in what is defined in the preambles of the independent claims presented below.

A method according to a preferred embodiment of the invention is typically characterised in that a measuring sensor component, operating by the electrostatic principle, advantageously operating by the electrostatic principle, is brought close to a line of a three-phase system, and then the alternating voltage field detected by the measuring sensor is transformed with the aid of electronics into square pulses, which then are directed to a processor for analysis with the aid of a synchronisation and comparison program section included in the processor.

The synchronisation program section of the processor comprises advantageously functions
- for identifying the rising edge of a square pulse of the synchronising phase,
- for calculating the average T of the pulse period, i.e. of the pulse interval, of the synchronising phase from a desired number of consecutive square pulses, and for storing them in a memory,
- for measuring the length t of a square pulse of the synchronising phase and for storing it in a memory, and
- for calculating the values t/2 and T/3 and for storing them in a memory.

The comparison program section of the processor comprises advantageously functions
- for storing the counter value t/2 in a register,
- for detecting any square pulse of the comparison phase received at the moment t/2 from the measuring sensor,
- for storing the counter value T/3 in a register, and
- for detecting any square pulse of the comparison phase received at the moment T/3 from the measuring sensor.

The processor further comprises functions
- for lighting a signal in the display component when a square pulse has been detected in the comparison phase.

Thus the synchronisation program section in the processor calculates the pulse length (t) from the first input signal (of the synchronising phase L1), and the pulse period or pulse interval (T) between two consecutive pulses. When the processor has determined these it is synchronised to the rising edge of the first input signal and indicates to the user that the synchronisation is obtained by lighting a signal, for instance a yellow light of a LED, after which the sensor can be moved to a another phase being the object of the comparison, the phase L2 or L3.

Then, at intervals corresponding to a third (T/3) of the pulse interval (the pulse period), the comparison program checks whether the sensor electronics has generated a square pulse to the processor when the sensor was moved to the position of another phase of the three-phase system. On the basis of the moment when the square pulse is detected the device concludes whether the measured phase is in advance, the same, or behind, compared to the synchronising phase. The device presents this to the user by lighting for instance a yellow LED, if the phases are the same, a green LED if the phase is behind, or a red LED if the phase is in advance of the phase used for the synchronisation.

Below the invention is described more closely with reference to the enclosed drawings, in which:
Figure 1 shows schematically in an axonometric presentation a device according to the invention,
Figure 2 shows in a diagram the operating principle of a device according to the invention, and
Figure 3 shows schematically, on a time axis divided into T/3 periods, pulse sequences obtained from different phases with a device according to the invention.

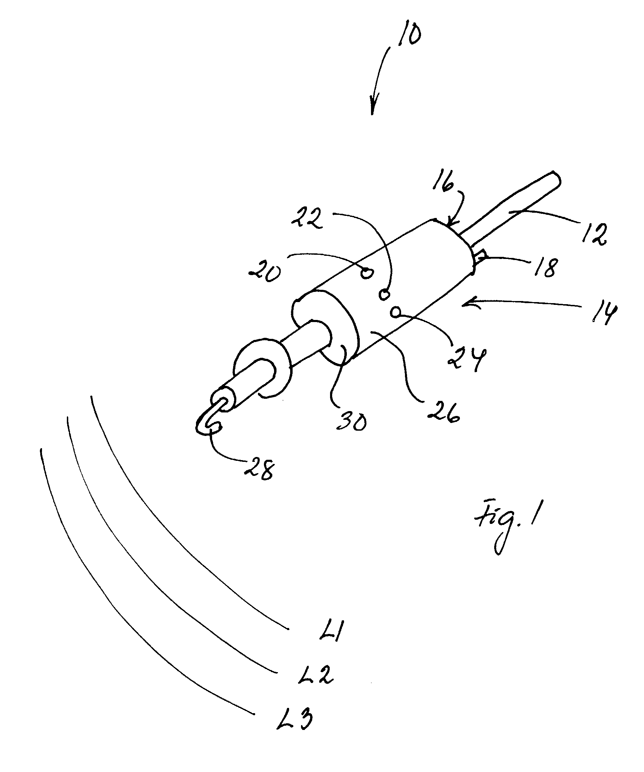

Figure 1 shows schematically a device 10 according to the invention which physically comprises a handle 12 and a case 14 fastened to the handle, whereby the device electronics is mounted within the case. A push-button 18 for starting the device is located in the end-plate 16 of the case 14, close to the handle. Signal means, in this case LEDs 20, 22, 24, providing information about the functions of the device are fastened to the cover plate 26 of the case and marked with texts describing their functions.

The measuring sensor 28 of the device is located in the end-plate 30 of the case opposite to the handle. The end of the measuring sensor is bent in order to facilitate the placing of the device for instance around the conductors or the phases L1, L2, L3 of a three-phase system which in the figure are shown only suggestively.

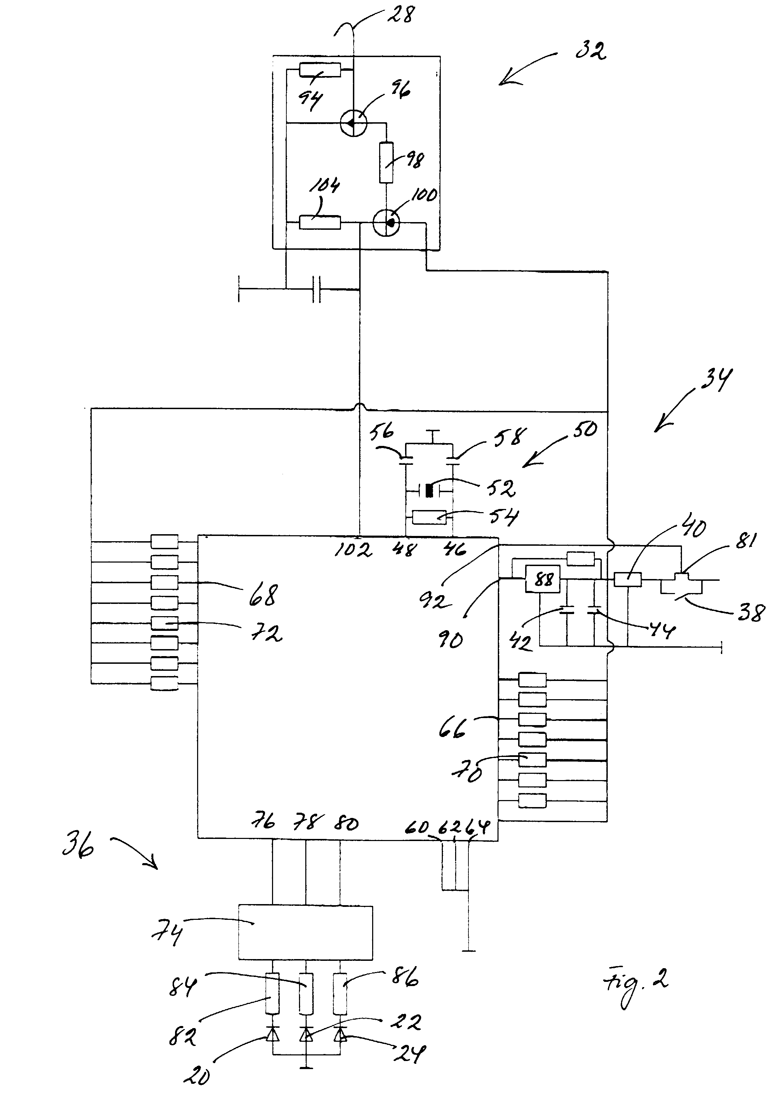

Functionally the device can be divided into the three parts shown in figure 2: a sensor part 32 which is connected to the measuring sensor 28, a signal processing or pulse comparison part 34 performed by a program which is programmed in the microprocessor, whereby microprocessor of this part is arranged in the case 14, and a display part 36 to which the LEDs 20, 22, 24 are connected.

The device comprises connected to the push-button 18 a switch 38, with which the device can be connected for instance to the circuit of a 9 V dc power supply, which is not shown in more detail in the figure. The device comprises further a regulator 40, with which the voltage is reduced to the 5 V operating voltage required by the electronics, and capacitors 42, 44 filtering away any interference which may appear in the operating voltage and which otherwise could interfere with the operation of the electronics.

To the inputs 46, 48 of the processor 34 there is connected a crystal circuit 50 which generates the 8 MHz clock frequency used by the processor. The crystal circuit is realised as a known circuit comprising a crystal 52, a resistor 54 and capacitors 56, 58. The processor 34 is further provided with a 16-bit cyclic counter running freely at the clock frequency, the counter being used by the program for time measurements.

In order to guarantee the correct operation of the processor 34 the processor inputs 60, 62, 64 are grounded, and the inputs 66, 68 are connected to the operating voltage +5 V via pull-up resistors 70, 72.

The display part 36 of the device comprises a control circuit 74 which is connected to the processor outputs 76, 78, 80. The control circuit is connected via the resistors 82, 84, 86 to the yellow 20, to the green 22 and to the red 24 LED.

When the phase sequence or the rotation direction of a three-phase system is measured the device is switched on by closing the switch 38, whereby the 5 V operating voltage is obtained from the 9 V circuit with the aid of the regulator 40. The capacitors 42, 44 filter away any interference which may appear in the operating voltage and which otherwise could interfere with the operation of the electronics. When the operating voltage is switched on the microcircuit 88 waits a moment before it supplies a reset signal to the input 90 of the microprocessor. A short delay in the reset signal ensures that the processor has had time to start reliably. The reset signal puts the processor into its basic state and starts the run of the program stored in the processor.

The crystal circuit 50 connected to the inputs 46, 48 of the processor 34 generates the 8 MHz clock frequency used by the processor. The program of the processor uses for the time measurements a 16-bit cyclic counter running freely at the clock frequency.

When the program of the processor is started it switches a voltage to the output 92 which puts a voltage controlled transistor (FET) 81 into the conducting state. When the voltage controlled transistor is in the conducting state the circuit stays connected to the power supply, even if the switch 38 would be opened.

If there is a voltage at the output 76 of the processor during the measurement the control circuit lights the yellow LED 20 functioning as a synchronisation pilot light. If there is a voltage at the output 78 the green LED 22 is lighted, which tells the user that the measured phase L2 or L3 is behind compared to the synchronising phase L1. If there is a voltage at the output 80 the red LED 24 is lighted, which tells that the measured phase L2, L3 is in advance compared to the synchronising phase L1.

Thus, in order to perform the phase comparison the device must first be synchronised to the first phase, for instance to the phase L1 in figure 1, in relation to which the phase comparison is desired. When the device is switched on the program of the processor indicates a lack of synchronisation by switching the output 76 periodically to the operating voltage and to the ground plane. To the user this appears as an even blinking of the yellow LED. If the synchronisation is not made within 14 seconds the program switches the output 92 to the ground plane, whereby the voltage controlled transistor 81 is switched into a non-conducting state and disconnects the operating voltage of the device. This prevents unnecessary draining of the battery acting as the power supply.

The synchronisation of the device is made by bringing the measuring sensor 28 close to the conductor L1 to be measured. The alternating current flowing in the conductor generates an alternating voltage field around the conductor. If the alternating voltage field is sufficiently strong it will induce, via the measuring sensor, a voltage over the resistor 94 at the base of the transistor 96. When the voltage rises so that it is sufficiently high the transistor 96 will switch into the conducting state, whereby there is generated a base voltage over the resistor 98 for the transistor 100, which is switched into the conducting state. Then the operating voltage can reach the input 102 of the processor.

when the alternating voltage field is weakened the voltage induced in the measuring sensor 28 will decrease at the base of the transistor 96 to a so low value that it is not able to keep the transistor in the conducting state. Then also the base voltage supplied via the resistor 98 to the base of the transistor 100 disappears and also the transistor 100 is switched into the non-conducting state. Then the input 102 of the processor is switched to the ground plane via the resistor 104. Effectively the sensor part of the device thus transforms the alternating voltage field detected by the measuring sensor 28 into a square pulse.

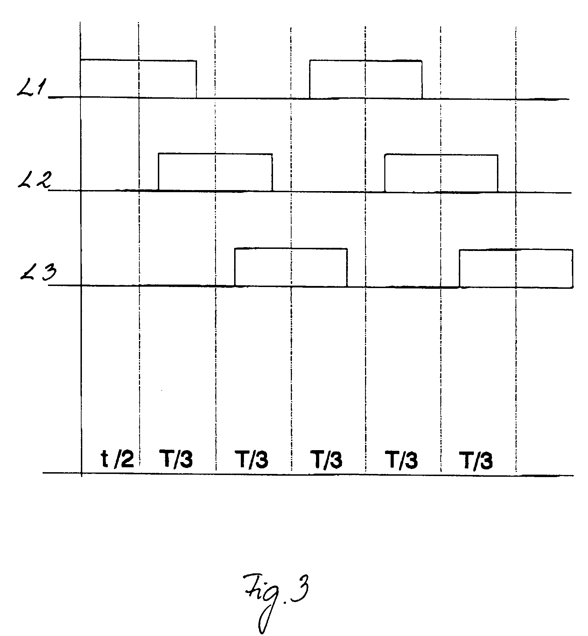

The functions of the microprocessor program are presented as an example in the enclosed three-page flow diagram, which presents how the phase sequence is measured in a three-phase system generating square pulses, for instance like those shown in figure 3, the system comprising the phases L1, L2, L3 shown in figure 1.

when the program has been initialised and when the initial definitions have been made the program will, when it detects the rising edge of a square pulse at the input 102 (when the voltage at the input 102 switches from the ground plane to the operating voltage), start to count with the aid of its internal counter the time which passes until the next rising edge is detected at the input 102. The program defines the time between these two rising edges as the pulse interval (the pulse period) T'. If the measured pulse interval does not fit the criteria given to the program the measurement result is discarded and a new pulse interval is measured.

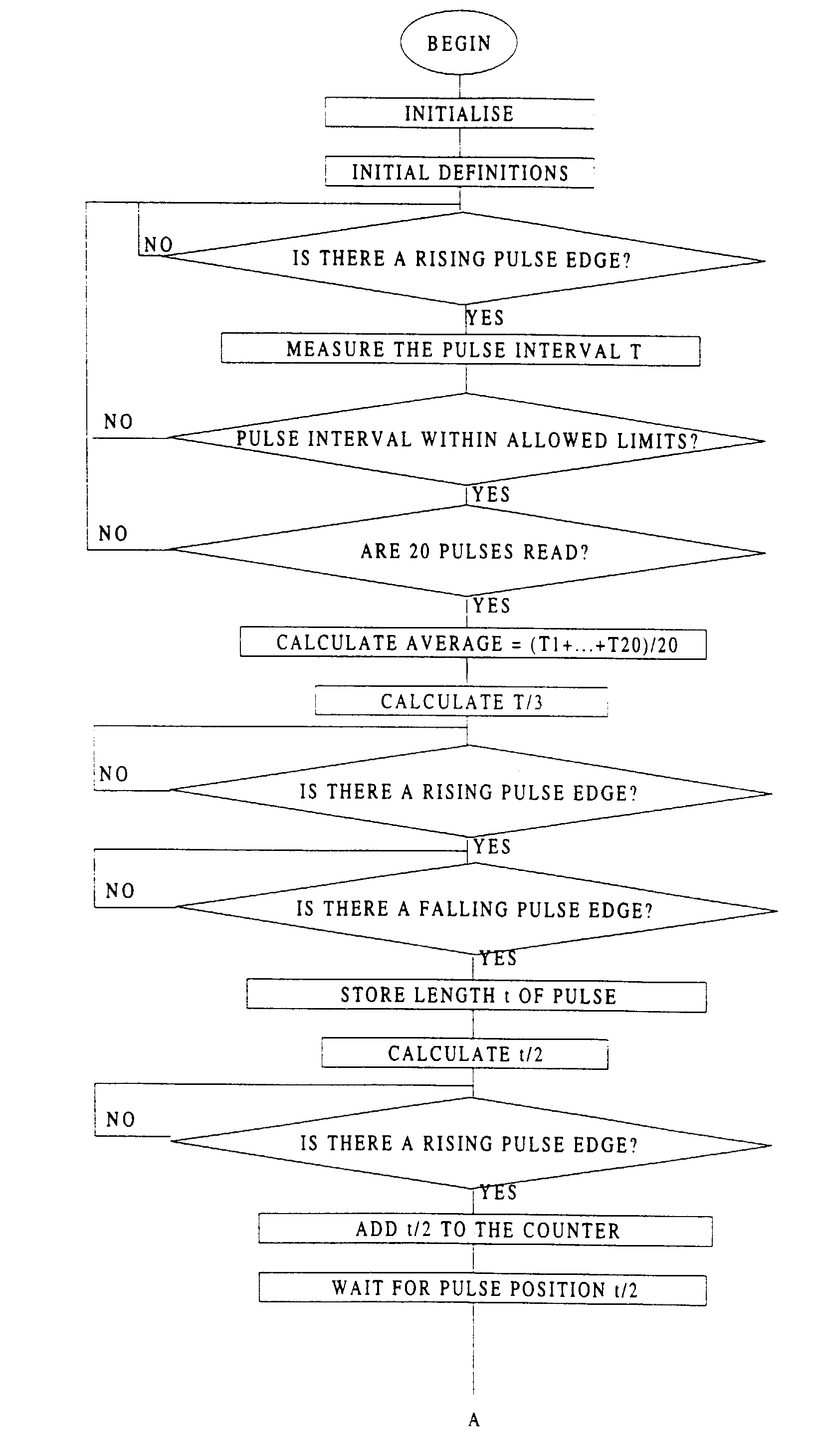

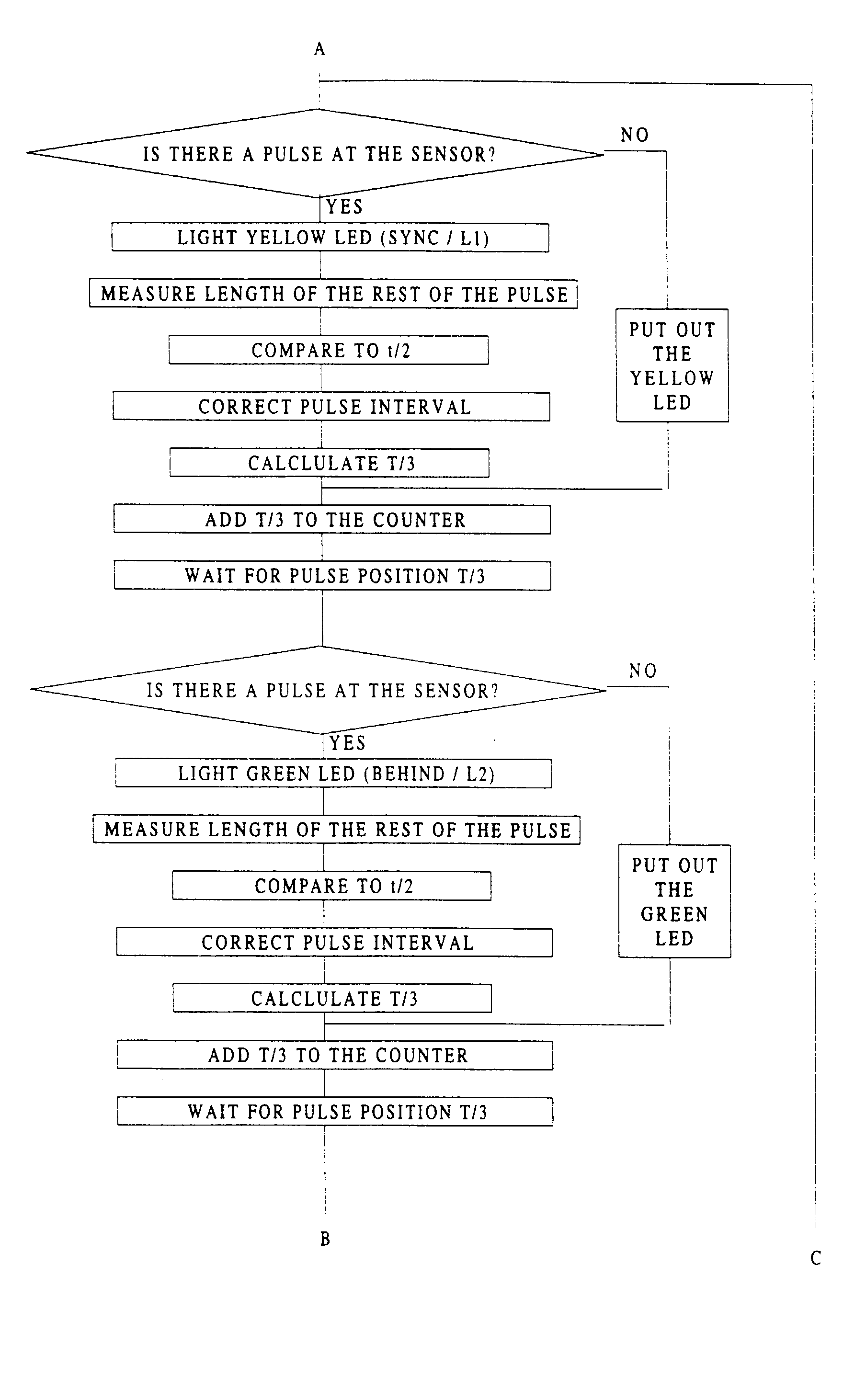

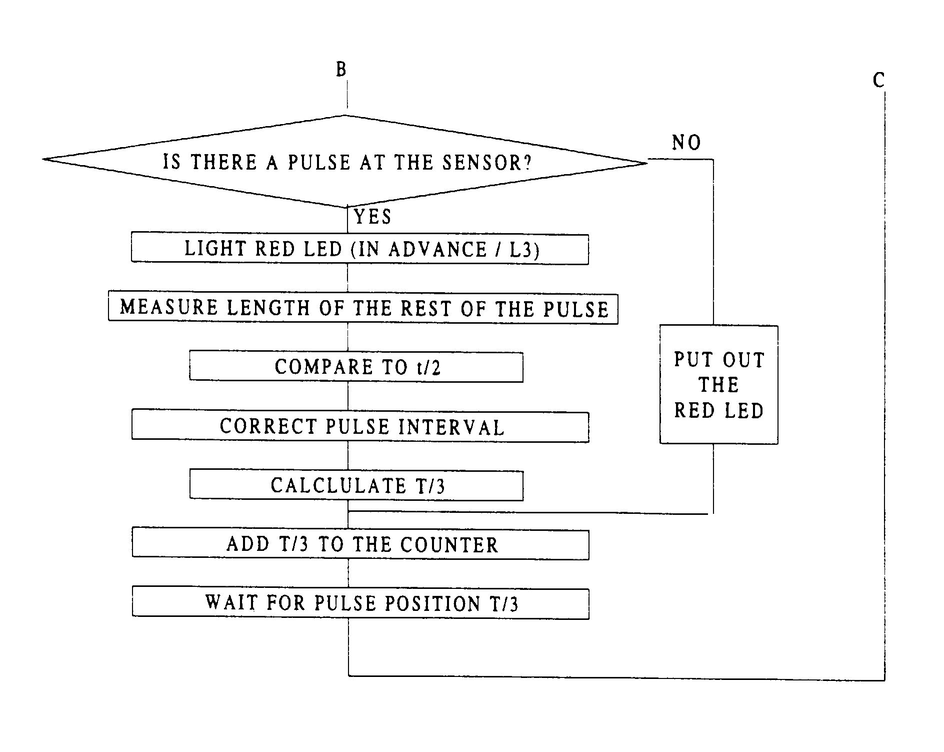

If the pulse interval fulfils the given criteria the value of the pulse interval is stored in a memory location, and a wait is begun for the next rising edge in order to calculate a new pulse interval. This is repeated until the values of for instance 5 to 30, typically of about 20 pulse intervals have been calculated. Then an average pulse interval T is calculated from the measured pulse interval values, and from this there is again calculated T/3 corresponding to a third of the pulse interval. Both values are stored in the memory.

when the pulse interval T and the third T/3 of it have been stored in the memory the program will again wait for a rising signal edge arriving at the input 102. When the program has detected a rising edge it counts with the aid of the counter the time which passes until at this time the falling edge of the square pulse is detected at the input 102. The program determines the time passed here to be the pulse length t, and then it calculates the value of the half pulse length t/2 and stores these in its memory.

Then the program again starts to wait for a rising edge of the signal supplied to the input 102, whereby the device has synchronised itself to the measured conductor, for instance to the conductor L1 in figure 1.

When the synchronisation is obtained the program passes directly to perform a phase comparison, for instance with the conductor or phase L2 in figure 1. The device starts the phase comparison by waiting a time corresponding to the value t/2 shown in figure 3 when it has detected a rising signal at the input 102.

Then the program starts to perform a programmed loop for 14 seconds. 14 seconds is the maximum time, during which the comparison measurement can be considered to be performed in a reliable way, due to possible frequency variations in the alternating voltage field to be measured. After 14 seconds the program switches off the processor and connects the output 92 to the ground plane, whereby the voltage controlled transistor 81 is switched into the non-conducting state which switches off the operating voltage of the device.

As the first step in the program loop the program checks whether there is a signal at the input 102. If there is a signal at the input this means that the phase, close to which the sensor 28 is at that moment, has the same phase as the reference phase. The program indicates this to the user by changing the output 76 to have a voltage, which in this way lights the yellow LED 20 to be continuously on.

When the blinking of the yellow LED stops and it is continuously lit it indicates a successful synchronisation to the user, whereby the user knows that he can go on to measure the phase L2, L3 to be compared.

Then the program determines the length of the rest of the square pulse by measuring the time which passes until the falling edge of the signal is detected at the input 102. The program compares the pulse length calculated in this way with the value t/2, and when they differ it corrects the value t/2 and calculates new pulse lengths T and T/3 with the aid of the newly corrected value t/2. This correction is advantageously made in order to compensate for any frequency variations occurring in the alternating voltage.

If the program did not detect a signal in the port 102 it connects the output 76 to the ground plane and puts out the yellow LED 20, if it may be lit.

when a new value T/3 was calculated, or, if the program did not detect a signal at the input 102 after the LED 20 was put out, the program waits a time corresponding to the value T/3 and then it examines whether there is now a signal at the input 102. If there is a signal at the input it means that the phase to be measured, for instance the phase L2, is behind when compared to the synchronising phase L 1. The program indicates this to the user by changing the output 78 to have a voltage, which causes the green LED 22 to be lit. Then the program determines the length of the rest of the square pulse and, when required, with the aid of this value it corrects the values t/2, T and T/3, as was presented above.

If the program did not detect a signal in the port 102 it connects the output 78 to the ground plane and puts out the green LED 22, if it may be lit.

when a new value T/3 was calculated, or, if the program did not detect a signal at the input 102 after the LED 22 was put out, the program waits a time corresponding to the value T/3 and then it examines whether there is now a signal at the input 102. If there is a signal at the input it means that the phase to be measured, for instance the phase L3, is in advance when compared to the synchronising phase L1. The program indicates this to the user by changing the output 80 to have a voltage, which causes the red LED 24 to be lit. Then the program determines the length of the rest of the square pulse and, when required, with the aid of this value it corrects the values used in the calculation according to what was presented above.

If the program did not detect a signal in the port 102 it connects the output 80 to the ground plane and puts out the red LED 224, if it may be lit.

when the calculation was made, or, if there was no signal at the input 102 after the led 24 was put out, the program again waits a time corresponding to the value T/3. In this step the program has been waiting a time corresponding to the value t/2 + T/3 + T/3 + T/3 = t/2 + T from the start of the comparison step. This corresponds to a situation where the phase having the same phase as the synchronising phase, for instance the phase L1, again generates a signal to the input 102. Therefore the program can return to the start of the loop.

The invention has provided a device which is reliable and simple which can be held in one hand for measuring the phase sequence and the rotation direction.

The invention is not intended to be limited to the above embodiment presented as an example, but it is intended to be broadly applied within the scope defined by the claims presented below.

## Claims

1. A device for measuring the phase sequence and the rotation direction of a three-phase system, whereby the device comprises
- a measuring sensor comprising a switch circuit in order to transform the voltage generated in the measuring sensor into square pulses,
- a processor for processing the square pulses received from the measuring sensor, whereby measuring sensor outputs are connected to the processor, which on the basis of the phase difference between the square pulses detects the rotation direction, and
- a display part having means indicating the rotation direction, such as LEDs, **characterised** in that the processor comprises
- a synchronisation program section, which comprises functions
- for identifying the rising edge of a square pulse of a synchronising phase,
- for calculating the average T of the pulse period, i.e. of the pulse interval, of the synchronising phase from a desired number of square pulses, advantageously consecutive square pulses, and for storing them in a memory,
- for measuring the length t of the square pulse of the synchronising phase and for storing it in a memory, and
- for calculating the values t/2 and T/3 and for storing them in a memory,
- and a comparison program section, which comprises functions
- for storing the counter value t/2 in a register,
- for detecting any square pulse of the comparison phase received at the moment t/2 from the measuring sensor,
- for storing the counter value T/3 in a register,
- for detecting any square pulse of the comparison phase received at the moment T/3 from the measuring sensor,
- and functions
- for lighting a signal in the display part when a square pulse has been detected in the comparison phase.

2. The device according to claim 1, **characterised** in that the measuring sensor operates by the electrostatic principle, and that the voltage generated in the sensor is transformed by an electronic switch circuit into square pulses.

3. The device according to claim 1, **characterised** in that the device comprises a crystal circuit which generates a clock frequency having a certain frequency.

4. The device according to claim 1, **characterised** in that the device comprises a 16-bit cyclic counter running freely at the clock frequency.

5. The device according to claim 1, **characterised** in that the device comprises a switch, with the aid of which the device can be connected to the circuit of a direct current power supply by pressing a push-button, and a voltage controlled transistor (FET) which, when being in the conducting state, keeps the circuit connected to the power supply even if the switch is opened.

6. The device according to claim 1, **characterised** in that the processor comprises a comparison program section, which comprises functions - for detecting any square pulse of the comparison phase received from the measuring sensor after several consecutive intervals T/3.

7. A method for measuring the phase sequence and the rotation direction of a three-phase system, with a device which comprises
- a measuring sensor comprising a switch circuit in order to transform the voltage generated in the measuring sensor into square pulses,
- a processor for processing the square pulses received from the measuring sensor, whereby measuring sensor outputs are connected to the processor which on the basis of the phase difference between the square pulses detects the rotation direction, and
- a display part having means indicating the rotation direction, such as LEDs, **characterised** in that
the processor comprising a synchronisation program section and a comparison program section provides
- by the synchronisation program section, functions
- for identifying the rising edge of the square pulse of the synchronising phase,
- for calculating the average (T) of the pulse period, i.e. of the pulse interval, of the synchronising phase from a desired number of square pulses, typically consecutive square pulses, and for storing them in a memory,
- for measuring the length (t) of the square pulse of the synchronising phase and storing it in a memory, and
- for calculating the values t/2 and T/3 and for storing them in a memory, and
- by the comparison program section, functions
- for storing the counter value t/2 in a register,
- for detecting any square pulse of the comparison phase received at the moment t/2 from the measuring sensor,
- for storing the counter value T/3 in a register,
- for detecting any square pulse of the comparison phase received at the moment T/3 from the measuring sensor,
- and functions
- for lighting a signal in the display part when a square pulse has been detected in the comparison phase.
